# EUROPEAN PATENT APPLICATION

(11) **EP 4 485 079 A1**
(43) Date of publication of application: **01.01.2025**
(21) Application number: 23214907.0
(22) Date of filing: 07.12.2023
(51) Int. Cl.: G03F 7/20, G03F 1/82

(54) **CONTROLLING ELECTROSTATIC CHARGE ON MASKS FOR EXTREME ULTRAVIOLET LITHOGRAPHY**

(30) Priority: 28.06.2023 US 202318215485
(71) Applicant: Intel Corporation, Santa Clara, CA 95054 (US)
(72) Inventor: KIM, Yongbae, San Jose, CA 95125 (US)
(74) Representative: HGF

(57) **Abstract**

Devices and processes for managing electrostatic charge on lithographic photomasks for semiconductor fabrication are provided. Exemplary devices include sensors for measuring the electrostatic charge on a lithographic photomask and charge injectors for modifying the electrostatic charge on a lithographic photomask. Exemplary devices are capable of attaching to carriers for lithographic photomasks. Exemplary processes include measuring the electrostatic charge on a lithographic photomask, calculating the amount that the electrostatic charge should be increased or decreased, and modifying the amount of electrostatic charge.

## Description

### FIELD

Descriptions are generally related to semiconductor processing, and more particular descriptions are related to equipment for extreme ultraviolet (EUV) photolithography and devices and methods for the control of electrostatic charges on EUV lithographic photomasks used in lithographic processes.

### BACKGROUND

Semiconductor chips are central to intelligent devices and systems, such as personal computers, laptops, tablets, phones, servers, and other consumer and industrial products and systems. Manufacturing semiconductor chips presents a number of challenges and these challenges are amplified as devices become smaller and performance demands increase. Challenges include, for example, unwanted material interactions, precision and scaling requirements, power delivery requirements, limited failure tolerance, and material and manufacturing costs.

Extreme ultraviolet (EUV) lithography is an optical lithography technique that uses light in the extreme ultraviolet wavelength range, below 100 nm and for example 13.5 nm in some applications, and that allows semiconductor device feature scaling to extremely small dimensions. Lithography in general is used in the semiconductor manufacturing industry to pattern a layer of photosensitive material, for example, a photoresist. To pattern the photoresist, a mask (also called a photomask, lithographic mask, or a lithographic photomask) is used as a template to create a light pattern which exposes only a portion of the photoresist. Depending on the type of photoresist selected, a subsequent process such as exposing the patterned surface to a solvent, removes either the exposed or the unexposed sections of the photoresist from the surface of the chip being manufactured. The patterned photoresist can then be used as a template to, for example, deposit materials onto or etch the surface of the chip in locations specified by the template. At extremely small feature sizes, the wavelength of light for lithographically patterning a photoresist becomes a limiting factor.

### BRIEF DESCRIPTION OF THE DRAWINGS

The figures are provided to aid in understanding the invention. The figures can include diagrams and illustrations of exemplary structures, assemblies, data, methods, and systems. For ease of explanation and understanding, these structures, assemblies, data, methods, and systems, the figures are not an exhaustively detailed description. The figures therefore should not be understood to depict the entire metes and bounds of structures, assemblies, data, methods, and systems possible without departing from the scope of the invention.
**Figures 1A - 1B** show example lithographic mask sections.
**Figures 2A** - **2C** provide exemplary electrostatic charge management devices.
**Figures 3A** - **3C** illustrate exemplary electrostatic charge management devices and a carrier for a lithographic mask.
**Figure 4** is a flow diagram of an example of a process for managing the electrostatic charge on a lithographic mask.
**Figure 5** provides an exemplary computing system that is part of an electrostatic charge management system.

Descriptions of certain details and implementations follow, including non-limiting descriptions of the figures, which depict examples, and implementations.

### DETAILED DESCRIPTION

References to one or more examples herein are to be understood as describing a particular feature, structure, or characteristic included in at least one implementation of the invention. The phrase "one example" or "an example" are not necessarily all referring to the same example or embodiment. Any aspect described can potentially be combined with any other aspect or similar aspect described herein, regardless of whether the aspects are described with respect to the same figure or element.

The words "connected" and/or "coupled" can indicate that two or more elements are in direct physical or electrical contact with each other. The term "coupled," however, can also mean that two or more elements are not in direct contact with each other and are instead separated by one or more elements but they may still co-operate or interact with each other, for example, physically, magnetically, or electrically.

The words "first," "second," and the like, do not indicate order, quantity, or importance, but rather are used to distinguish one element from another. The words "a" and "an" herein do not indicate a limitation of quantity, but rather denote the presence of at least one of the referenced items. The terms "follow" or "after" can indicate immediately following or following after some other event or events. Other sequences of operations can also be performed according to alternative embodiments. Furthermore, additional operations may be added or removed depending on the particular application.

Disjunctive language such as the phrase "at least one of X, Y, or Z," is used in general to indicate that an element or feature, may be either X, Y, or Z, or any combination thereof (e.g., X, Y, and/or Z). Thus, this disjunctive language should be understood not to imply that certain embodiments require at least one of X, at least one of Y, or at least one of Z to each be present.

Terms such as chip, die, IC (integrated circuit) chip, IC die, or semiconductor chip are used interchangeably and refer to a semiconductor device comprising integrated circuits. Chips are manufactured in wafer form where a wafer contains a number of chips. After manufacture, the wafer is diced apart to create chips.

Flow diagrams as illustrated herein provide examples of sequences of various process actions. The flow diagrams can indicate operations to be executed by a software or firmware routine, as well as physical operations. Although shown in a particular sequence or order, unless otherwise specified, the order of the actions can be modified. Thus, the illustrated diagrams should be understood only as examples, and the process can be performed in a different order, and some actions can be performed in parallel. Additionally, one or more actions can be omitted and not all implementations will perform all actions.

Various components described can be a means for performing the operations or functions described. Each component described includes software, hardware, or a combination of these. Some components can be implemented as software modules, hardware modules, special-purpose hardware (for example, application specific hardware, application specific integrated circuits (ASICs), digital signal processors (DSPs), etc.), embedded controllers, hardwired circuitry).

To the extent various computer operations or functions are described herein, they can be described or defined as software code, instructions, configuration, and/or data. The software content can be provided via an article of manufacture with the content stored thereon, i.e., a non-transitory storage medium, or via a method of operating a communication interface to send data via the communication interface. A machine readable storage medium can cause a machine to perform the functions or operations described, and includes any mechanism that stores information in a tangible form accessible by a machine (e.g., computing device), such as recordable/non-recordable media (e.g., read only memory (ROM), random access memory (RAM), magnetic disk storage media, optical storage media, flash memory devices). A communication interface includes any mechanism that interfaces to, for example, a hardwired, wireless, or optical medium to communicate to another device, such as, for example, a memory bus interface, a processor bus interface, an Internet connection, a disk controller.

Masks used in EUV lithography can build up electrostatic charges in their surfaces despite careful management of the lithographic photomasks and clean rooms where they are used. These electrostatic charges can be, for example, the result of use of the lithographic photomask during semiconductor fabrication. Electrostatic charges on EUV lithographic photomask surfaces can result in electrostatic discharge-related damage and defects. Static charge can transfer between objects even without contact through an induced electric field. Additionally, static charge on mask surfaces interferes with critical dimension (CD) measurements, such as CD measurements of masks conducted by electron microscope. It is important not only to be able to quantify electrostatic charge on masks but also to mitigate it.

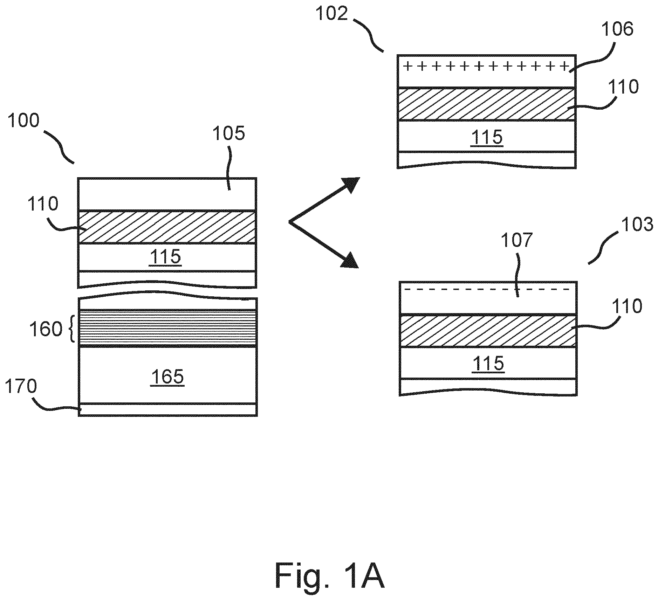

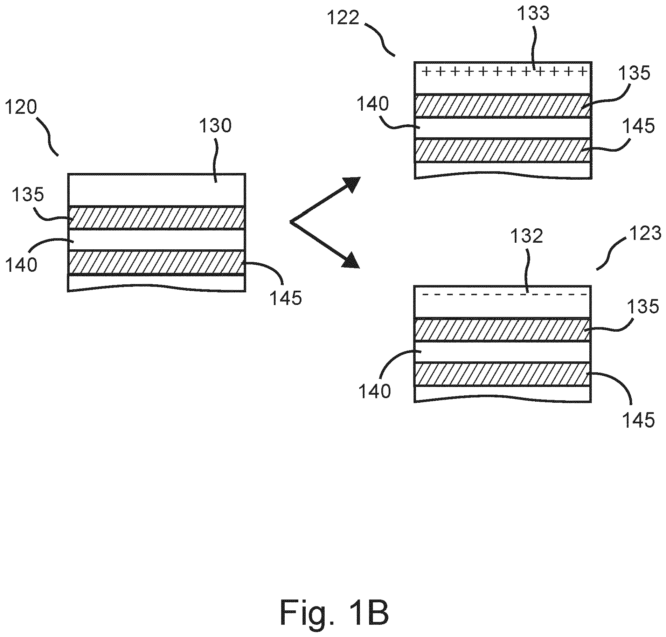

Figures 1A-1B provide examples of sections of EUV lithographic photomasks and illustrate charge build-up on the surface of the masks. EUV lithographic photomasks are typically comprised of layers of dielectric materials and of layers of conducting materials. Lithographic photomasks in general can have different designs than the ones described here. Invention examples are useful for lithographic photomasks generally, and are not limited to the example lithographic photomasks provided here for explanation. Additionally, the charge distributions shown in Figures 1A and 1B are provided for explanation and only display charge distribution at the top of the lithographic photomasks, actual positive or negative charge distributions in the film structures of lithographic photomasks can be more complex.

In Figure 1A, an EUV lithographic photomask section 100 has a first dielectric layer 105, a conducting layer 110, and a second dielectric layer 115. Additional layers of the lithographic photomask section 100 include, for example, a region 160 comprised of multilayers of silicon (Si) and molybdenum (Mo), a substrate 165 comprised of quartz, and a metal layer 170. The multilayer region 160 can comprise, for example, 30-50 pairs of thin Si and Mo layers. The substrate 165 can comprise trace amounts of metallic elements, such as, for example, titanium (Ti). Titanium doping in quartz, for example, can reduce the substrate's 165 coefficient of thermal expansion. Mask section 102 shows a positive charge that has developed in dielectric layer 105 of structure 100. Exposed dielectric layer 106 in EUV lithographic photomask section 102 has a positive charge. In the alternative, depending on conditions, a negative charge can build up on the surface dielectric layer 105 and EUV lithographic photomask section 103 shows a negative charge that has developed in surface dielectric layer 107.

In Figure 1B, an example EUV lithographic photomask section 120 includes a surface metal layer 130, an interior dielectric layer 135, an interior metal layer 140 and a second dielectric layer 145. As in Figure 1A, additional layers of the lithographic photomask section 120 can include, for example, a region 160 comprised of multilayers of silicon (Si) and molybdenum (Mo), a substrate 165 comprised of quartz, and a metal layer 170.

Lithographic photomask structure 122 shows a positive charge build up on metal layer 133 of lithographic photomask structure 120, layer 130. Lithographic photomask structure 123 demonstrates how a surface metal layer 130 can develop a negative charge. In structure 123, surface metal layer 132 illustrates the negative charge.

In Figures 1A and 1B, an EUV mask dielectric layer is, for example, Ta₂O₅, TaBON, SiO₂, Si, and/or photoresist. The material of a conducting layer of an EUV lithographic photomask is, for example, Ru, RuN, TaN, TaBN, Ti, TiN and/or Mo. As can be seen from Figures 1A-1B, the electrostatic charge can be either positive or negative. Lithographic photomasks can comprise other numbers or compositions of layers than the ones shown here as examples. The electrostatic charges that form on lithographic photomasks in general, can be different amounts that are localized in regions of the mask surface. A failure mechanism for lithographic photomasks involves charge imbalances in regions of a mask surface. These localized charge imbalances can lead to static discharges that damage the mask.

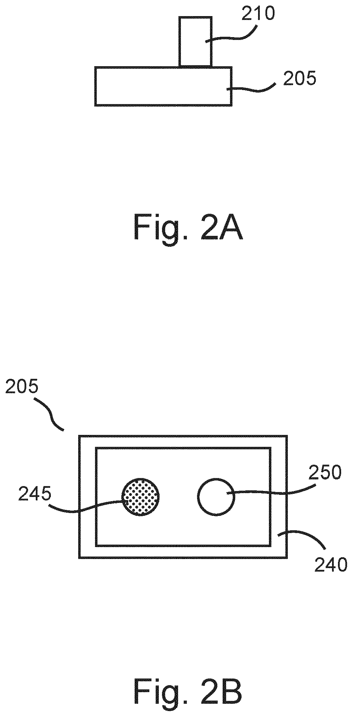

Figures 2A-2C illustrate exemplary devices for managing electrostatic charge on a lithographic photomask. The lithographic photomask can be an EUV lithography mask. In Figure 2A, the device for managing electrostatic charge includes an electrostatic charge measurement and modification unit 205 and control unit 210. The control unit 210 can be either physically attached to the electrostatic charge measurement and modification unit 205, as shown in Figure 2A, or it can be, for example, part of computing unit or system (not shown), that is separate from the electrostatic charge measurement and modification unit 205. The control unit 210 can also be coupled to the electrostatic charge measurement and modification unit 205 through a cordless link or a corded. In the case that the charge measurement and modification unit 205 is physically separate from the control unit 210, it can communicate with the control unit 210, for example, either through a wired communication connection or a wireless communication connection. Functions performed by the control unit 210 include receiving electrostatic charge measurement input from the electrostatic charge measurement and modification unit 205 and causing the electrostatic charge measurement and modification unit 205 to modify the electrostatic charge on a lithographic photomask a specified amount. The control unit 210 is also capable of storing, outputting, or storing and outputting a value for the charge on the lithographic photomask. The modification of electrostatic charge on a lithographic photomask includes reducing the positive electrostatic charge, reducing a negative electrostatic charge, increasing a positive electrostatic charge, and/or increasing a negative electrostatic charge.

The control unit 210 can include, for example, software, hardware, or a combination of software and hardware or the functions can be part of a larger computing system. In some examples, the control unit 210, includes additional intelligence and can calculate values for the amount that the charge needs to be modified to cause the lithographic photomask to perform repeatedly and as desired under a selected situation, such as, for example, during lithography or during mask health analysis (e.g., CD measurements). In some examples, the control unit 210 directs the modification of electrostatic charge values to push the surface to a near zero average electrostatic charge value. In other examples, the control unit 210 directs the modification of an average electrostatic charge value to a positive or negative value that is selected to optimize mask reliability during a selected process. For example, reliability can be the mask functioning repeatably and as desired during a process and/or reliability can be increasing the overall mask life, so that the mask does not undergo catastrophic failure during a process.

In additional examples, control unit 210 functions can include creating a map of charge amount for a mask surface where the map includes mask surface locations and charge amount data. A surface location is associated with a charge amount. The map may be used to modify one area of charge on a lithographic photomask in a different amount than a second area. Control unit 210 functions can optionally include directing the electrostatic charge measurement and modification unit 205 to modify the amount of charge on a first region more or less than how much the charge is to be modified on a second region on a mask surface.

The control unit 210 can itself perform all of the forgoing functions, it can perform a subset of the foregoing functions, and/or it can perform additional functions. Some functions, for example, could be performed by the control unit 210 and some functions could be performed by one or more separate computing devices.

Figures 2B-2C illustrate the electrostatic charge measurement and modification unit 205 rotated relative to Figure 2A. Figures 2B-2C illustrate possible configurations for a side of electrostatic charge measurement and modification unit 205 that faces a lithographic photomask and that allows modification of the electrostatic charge of a lithographic photomask (not shown). In Figure 2B, the electrostatic charge measurement and modification unit 205 has a housing 240 that holds a sensor 245 capable of detecting electrostatic charges and a charge injector 250. The sensor 245 is, for example, an electrostatic sensor that monitors electrostatic charge. The charge injector 250 is, for example, an ionizer, a static removal device, or a corona discharge static removal device. The housing 240 can have a shape, size, and configuration, for example, that enables it to interface with a lithographic photomask and/or to interface with a carrier for a lithographic photomask.

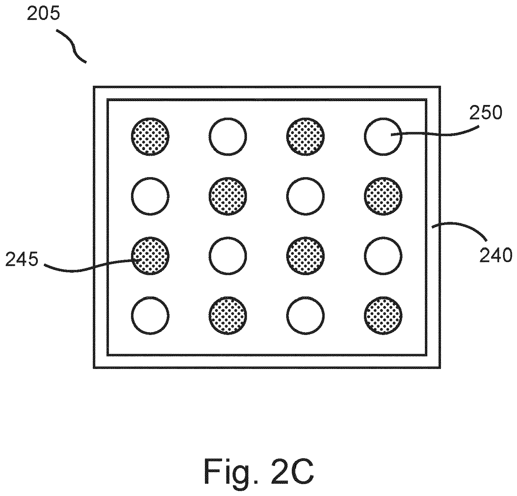

Figure 2C illustrates an additional example of an electrostatic charge measurement and modification unit 205 having a plurality of both sensors 245 and charge injectors 250 within housing 240. The electrostatic charge measurement and modification unit 205 is shown in this example as having the same number of sensors 245 and charge injectors 250, however there can be different numbers of each. Additionally, different numbers than the illustrated numbers of sensors 245 and charge injectors 250 are also possible.

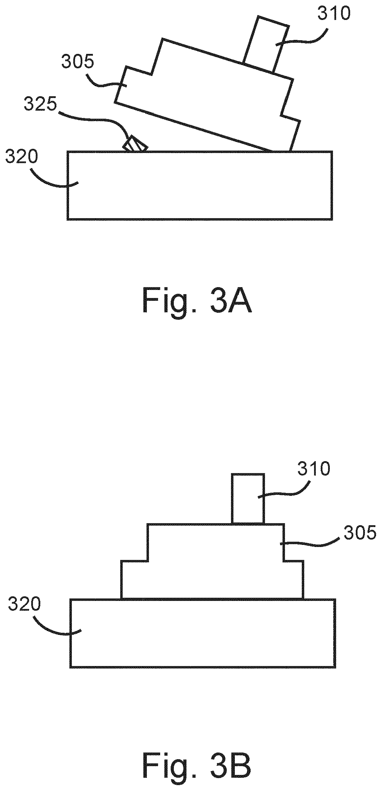

Figures 3A-3C illustrate an exemplary device for managing electrostatic charge on a lithographic photomask associated with a carrier for a lithographic photomask. Other types and configurations of lithographic mask carriers are possible. The carrier can be a box, a pod, or other type of enclosure, for example. The carrier protects the lithographic mask from environmental challenges. The lithographic mask can be an EUV lithography mask and the carrier a carrier for an EUV lithography mask. Figure 3A shows an exemplary charge management device being placed on a carrier for a photolithographic mask. Figure 3B shows the exemplary charge management device positioned to measure and modify the charge of a lithographic mask (not shown).

In Figures 3A-3B, the device for managing electrostatic charge on a lithographic photomask includes an electrostatic charge measurement and modification unit 305 and control unit 310. The electrostatic charge measurement and modification unit 305 includes a housing that allows it to interface with the carrier for a lithographic photomask 320. In some examples, the cover (not shown) for the carrier for the lithographic photomask 320 has been removed and replaced by the device for managing electrostatic charge. In other examples, the device for managing electrostatic charge also includes a carrier 320 for a lithographic photomask. The control unit 310 can be either physically attached to the electrostatic charge measurement and modification unit 305, as shown in Figures 3A-3B, or it can be for example, part of computing system (not shown), that is separate from the electrostatic charge measurement and modification unit 305. In the case that the charge measurement and modification unit 305 is physically separate from the control unit 310, it can communicate with the control unit 310, for example, either through a wired communication connection or a wireless communication connection. Functions performed by the control unit 310 include receiving electrostatic charge measurement input from the electrostatic charge measurement and modification unit 305 and causing the electrostatic charge measurement and modification unit 305 to modify the electrostatic charge on a lithographic photomask a specified amount. The control unit 305 is also capable of storing, outputting, or storing and outputting a value for the charge on the lithographic photomask. Properties of the control unit 310 also include those described with respect to Figures 2A-2C.

In Figures 3A-3C the carrier for a lithographic photomask includes lithographic photomask retaining mechanisms 325. The lithographic photomask retaining mechanism 325 is optional. The lithographic photomask retaining mechanism 325 can also optionally be more than one retaining piece into which the lithographic photomask can be placed. The lithographic photomask retaining mechanism 325 can additionally be one or more supports for a lithographic photomask. The electrostatic charge measurement and modification unit 305 is either fixed to or removably attached to the lithographic photomask carrier 320. When closed, the carrier for the lithographic photomask is capable of enclosing the lithographic photomask in an interior region. In some examples of Figure 3B, the lithographic photomask is enclosed and protected from the surrounding environment, including from airborne contaminants, electrostatic fluctuations, and other types of physical, chemical, and/or electrical harm.

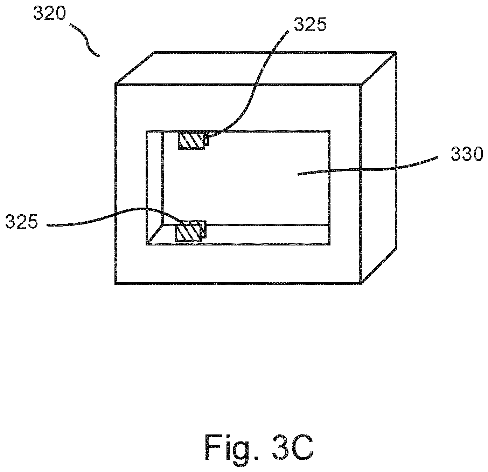

Figure 3C provides a simplified example of an interior for the carrier 320 for a lithographic photomask. The carrier 320 comprises an interior region 330. Although in this example, the interior region 330 is shown for the carrier 320, the electrostatic charge measurement and modification unit 305 could also or instead comprise an interior region capable of accepting all or part of a lithographic photomask.

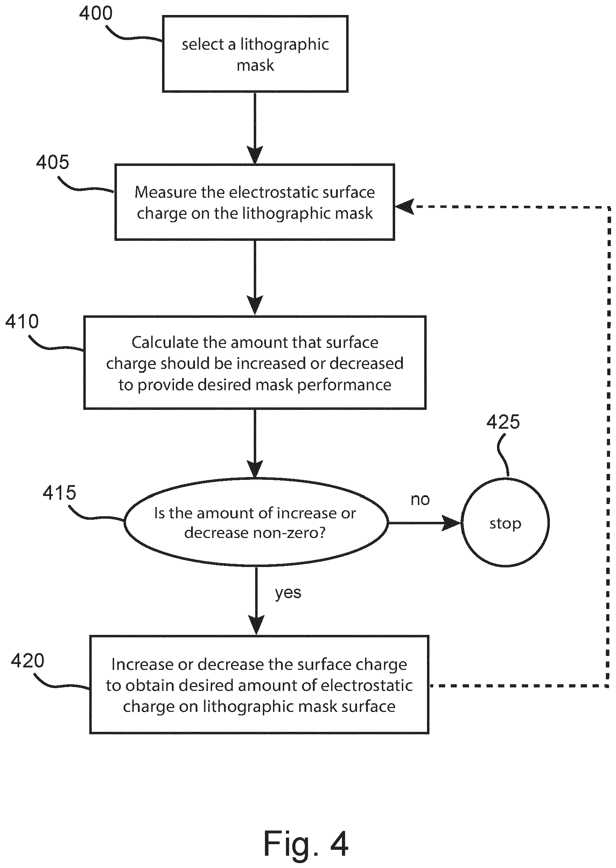

Figure 4 provides an exemplary process flow for managing the electrostatic charge on a lithographic photomask, such as an EUV lithography mask. In Figure 4, a lithographic photomask, such as, for example, an EUV lithography mask, for which evaluation and possible modification of electrostatic charge is desired is selected 400. The electrostatic charge on the lithographic photomask is measured 405. The measurement of electrostatic charge optionally also includes creating a map of electrostatic charge amount for a mask surface where the map includes mask surface location and charge amount data. The amount of electrostatic charge that is measured is compared to a desired amount of electrostatic charge and a difference is calculated 410. The difference is the amount the electrostatic charge should be increased or decreased 410. If the electrostatic charge is at a desired amount, that is if the difference is zero, there is no electrostatic charge change needed 425. If the amount of increase or decrease is non-zero 415, then the electrostatic charge is increased or decreased to the desired amount 420. The measured electrostatic charge on the lithographic photomask can be positive or negative, and increasing the electrostatic charge increases the amount of positive charge or increases the amount of negative charge. Decreasing the electrostatic charge can decrease the amount of positive charge or can decrease the amount of negative charge on the surface of the lithographic photomask. Optionally, the map is used to modify at least one area of charge on a lithographic photomask in a different amount than a second area. For example, if the mask indicates there are several regions of high electrostatic charge, several regions of medium electrostatic charge, and a region of low electrostatic charge, the electrostatic charge can be decreased a more in the high charge region, less in the medium charge region, and not at all in the low charge region, if the desired result is a mask with near zero or very low electrostatic charge. Devices according to Figures 2A-2C and Figures 3A-3C can be used to modify electrostatic charges, for example, in the method described by Figure 4. Optionally, the method of Figure 4 is an iterative process where after the electrostatic charge is initially increased or decreased, the electrostatic charge is again measured 405, an amount the charge should be changed is calculated 410, and the electrostatic charge is modified a second time 420. An iterative process can be performed one or more times until the electrostatic charge is measured to be at a desired level.

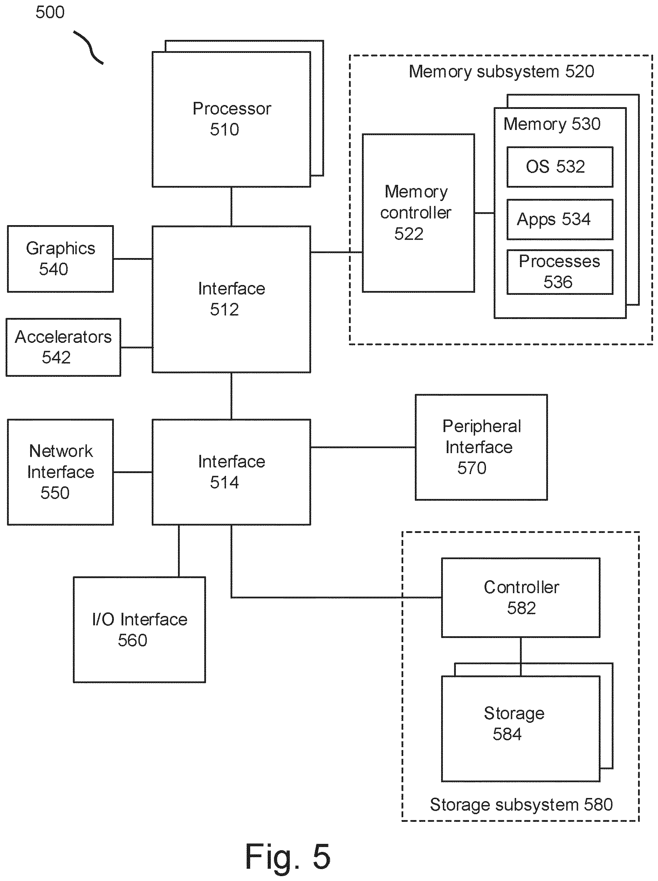

Figure 5 depicts an example computing system which can be used in conjunction with electrostatic charge management devices. The computing system can be, for example, a system used for running equipment in a semiconductor fabrication plant. For example, instructions for operating electrostatic charge management devices, or for performing one or more aspects of the process described in Figure 4 can be stored and/or run on the computing system. In this example, the system is communicatively coupled to one or more electrostatic charge management devices. The computing system employed can include more, different, or fewer features than the one described with respect to Figure 5.

Computing system 500 includes processor 510, which provides processing, operation management, and execution of instructions for system 500. Processor 510 can include any type of microprocessor, CPU (central processing unit), GPU (graphics processing unit), processing core, or other processing hardware to provide processing for system 500, or a combination of processors or processing cores. Processor 510 controls the overall operation of system 500, and can be or include, one or more programmable general-purpose or special-purpose microprocessors, DSPs, programmable controllers, ASICs, programmable logic devices (PLDs), or the like, or a combination of such devices.

In one example, system 500 includes interface 512 coupled to processor 510, which can represent a higher speed interface or a high throughput interface for system components needing higher bandwidth connections, such as memory subsystem 520 or graphics interface components 540, and/or accelerators 542. Interface 512 represents an interface circuit, which can be a standalone component or integrated onto a processor die. Where present, graphics interface 540 interfaces to graphics components for providing a visual display to a user of system 500. In one example, the display can include a touchscreen display.

Accelerators 542 can be a fixed function or programmable offload engine that can be accessed or used by a processor 510. For example, an accelerator among accelerators 542 can provide data compression (DC) capability, cryptography services such as public key encryption (PKE), cipher, hash/authentication capabilities, decryption, or other capabilities or services. In some cases, accelerators 542 can be integrated into a CPU socket (e.g., a connector to a motherboard (or circuit board, printed circuit board, mainboard, system board, or logic board) that includes a CPU and provides an electrical interface with the CPU). For example, accelerators 542 can include a single or multi-core processor, graphics processing unit, logical execution unit single or multi-level cache, functional units usable to independently execute programs or threads, application specific integrated circuits (ASICs), neural network processors (NNPs), programmable control logic, and programmable processing elements such as field programmable gate arrays (FPGAs) or programmable logic devices (PLDs). Accelerators 542 can provide multiple neural networks, CPUs, processor cores, general purpose graphics processing units, or graphics processing units can be made available for use by artificial intelligence (AI) or machine learning (ML) models.

Memory subsystem 520 represents the main memory of system 500 and provides storage for code to be executed by processor 510, or data values to be used in executing a routine. Memory subsystem 520 can include one or more memory devices 530 such as read-only memory (ROM), flash memory, one or more varieties of random access memory (RAM) such as static RAM (SRAM), dynamic RAM (DRAM), synchronous DRAM (SDRAM) and/or or other memory devices, or a combination of such devices. Memory 530 stores and hosts, among other things, operating system (OS) 532 to provide a software platform for execution of instructions in system 500, and stores and hosts applications 534 and processes 536. In one example, memory subsystem 520 includes memory controller 522, which is a memory controller to generate and issue commands to memory 530. The memory controller 522 could be a physical part of processor 510 or a physical part of interface 512. For example, memory controller 522 can be an integrated memory controller, integrated onto a circuit within processor 510.

System 500 can also optionally include one or more buses or bus systems between devices, such memory buses, graphics buses, and/or interface buses. Buses or other signal lines can communicatively or electrically couple components together, or both communicatively and electrically couple the components. Buses can include physical communication lines, point-to-point connections, bridges, adapters, controllers, or other circuitry or a combination. Buses can include, for example, one or more of a system bus, a peripheral component interconnect (PCI) or PCIe (PCI express) bus, a Hyper Transport or industry standard architecture (ISA) bus, a small computer system interface (SCSI) bus, a USB (universal serial bus), or a Firewire bus.

In one example, system 500 includes interface 514, which can be coupled to interface 512. In one example, interface 514 represents an interface circuit, which can include standalone components and integrated circuitry. In one example, user interface components or peripheral components, or both, couple to interface 514. Network interface 550 provides system 500 the ability to communicate with remote devices (e.g., servers or other computing devices) over one or more networks. Network interface 550 can include an Ethernet adapter, wireless interconnection components, cellular network interconnection components, USB, or other wired or wireless standards-based or proprietary interfaces. Network interface 550 can transmit data to a device that is in the same data center or rack or a remote device, which can include sending data stored in memory.

Some examples of network interface 550 are part of an infrastructure processing unit (IPU) or data processing unit (DPU), or used by an IPU or DPU. An xPU can refer at least to an IPU, DPU, GPU, GPGPU (general purpose computing on graphics processing units), or other processing units (e.g., accelerator devices). An IPU or DPU can include a network interface with one or more programmable pipelines or fixed function processors to perform offload of operations that could have been performed by a CPU. The IPU or DPU can include one or more memory devices.

In one example, system 500 includes one or more input/output (I/O) interface(s) 560. I/O interface 560 can include one or more interface components through which a user interacts with system 500 (e.g., audio, alphanumeric, tactile/touch, or other interfacing). Peripheral interface 570 can include additional types of hardware interfaces, such as, for example, interfaces to semiconductor fabrication equipment and/or electrostatic charge management devices.

In one example, system 500 includes storage subsystem 580. Storage subsystem 580 includes storage device(s) 584, which can be or include any conventional medium for storing data in a nonvolatile manner, such as one or more magnetic, solid state, and/or optical based disks. Storage 584 can be generically considered to be a "memory," although memory 530 is typically the executing or operating memory to provide instructions to processor 510. Whereas storage 584 is nonvolatile, memory 530 can include volatile memory (e.g., the value or state of the data is indeterminate if power is interrupted to system 500). In one example, storage subsystem 580 includes controller 582 to interface with storage 584. In one example controller 582 is a physical part of interface 512 or processor 510 or can include circuits or logic in both processor 510 and interface 514.

A power source (not depicted) provides power to the components of system 500. More specifically, power source typically interfaces to one or multiple power supplies in system 500 to provide power to the components of system 500.

Exemplary systems may be implemented in various types of computing, smart phones, tablets, personal computers, and networking equipment, such as switches, routers, racks, and blade servers such as those employed in a data center and/or server farm environment.

Besides what is described herein, various modifications can be made to what is disclosed and implementations of the invention without departing from their scope. Therefore, the illustrations and examples herein should be construed in an illustrative, and not a restrictive sense. The scope of the invention should be measured solely by reference to the claims that follow.

The following section of the description relates to further examples. The numbered paragraphs in this section are not claims. The claims are set forth below in the later section headed "claims".
1. An assembly comprising: a sensor, wherein the sensor is capable of measuring electrostatic charge on a lithographic photomask; a charge injector, wherein the charge injector is capable of modifying the electrostatic charge on a lithographic photomask; a housing wherein the sensor and the charge injector are in the housing; and a control unit wherein the control unit is capable of causing the sensor to measure the electrostatic charge on the lithographic photomask, is capable of storing, outputting, or storing and outputting a value for the charge on the lithographic photomask, and is capable of causing the charge injector to modify the charge on a lithographic photomask a specified amount.
2. The assembly of clause 1, additionally comprising at least part of a carrier for a lithographic photomask, wherein the housing is attached to the at least part of a carrier for a lithographic photomask.
3. The assembly of clause 1, wherein the housing is capable of attaching to a part of a carrier for a lithographic photomask.
4. The assembly of clause 1, wherein the lithographic photomask is an extreme ultraviolet (EUV) lithographic photomask.
5. The assembly of clause 1, wherein the assembly comprises a plurality of charge injectors.
6. The assembly of clause 1, wherein the assembly comprises a plurality of sensors.
7. The assembly of clause 1 wherein the control unit is additionally capable of determining the specified amount from a measurement of electrostatic charge on the lithographic photomask and a selected value for electrostatic charge on the lithographic photomask.
8. A system comprising: a sensor, wherein the sensor is capable of measuring electrostatic charge on a lithographic photomask; a charge injector, wherein the charge injector is capable of modifying the electrostatic charge on a lithographic photomask; a housing wherein the sensor and the charge injector are in the housing; a control unit wherein the control unit is capable of causing the sensor to measure the charge on a lithographic photomask, is capable of outputting, or storing and outputting a value for the charge on the lithographic photomask, and is capable of causing the charge injector to modify the charge on a lithographic photomask a specified amount; and a computing system, wherein the computing system is capable of determining an amount for modifying the electrostatic charge on a lithographic photomask based on a selected value for electrostatic charge and an output value from the control unit, and wherein the computing system is communicatively coupled to the control unit.
9. The system of clause 8, wherein the computing system is additionally capable of creating a map of charge amount for a lithographic photomask surface where the map includes lithographic photomask surface locations and charge amounts.
10. The system of clause 8, wherein additionally comprising at least part of a carrier for a lithographic photomask, wherein the housing is attached to the at least part of a carrier for a lithographic photomask.
11. The system of clause 8, wherein the lithographic photomask is an extreme ultraviolet (EUV) lithographic photomask.
12. The system of clause 8, wherein the system comprises a plurality of charge injectors in the housing.
13. The system of clause 8, wherein the system comprises a plurality of sensors in the housing.
14. A method for modifying electrostatic charge on a lithographic photomask comprising:
   measuring electrostatic charge on a lithographic photomask; calculating an amount that the measured electrostatic charge on the lithographic photomask is to be changed based on a selected electrostatic charge amount and the measured electrostatic charge amount; and
   modifying the amount of electrostatic charge on the lithographic photomask based on the calculated amount.
15. The method of clause 14 wherein the lithographic photomask is an extreme ultraviolet (EUV) lithographic photomask.
16. The method of clause 14 also including measuring electrostatic charge on a lithographic photomask a second time.
17. The method of clause 14 wherein the amount of electrostatic charge on the lithographic photomask is decreased.
18. The method of clause 14 wherein the amount of electrostatic charge on the lithographic photomask is increased.
19. The method of clause 14 also including creating a map of electrostatic charge amount for the lithographic photomask where the map includes lithographic photomask surface locations and electrostatic charge amounts.
20. The method of clause 14 also including measuring electrostatic charge on a lithographic photomask a second time and modifying the amount of electrostatic charge on the lithographic photomask based on a calculated amount.

## Claims

1. An assembly comprising:
a sensor, wherein the sensor is capable of measuring an electrostatic charge on an extreme ultraviolet (EUV) lithographic photomask;
a charge injector, wherein the charge injector is capable of modifying the electrostatic charge on an EUV lithographic photomask;
a housing wherein the sensor and the charge injector are in the housing; and
a control unit wherein the control unit is capable of causing the sensor to measure the electrostatic charge on the EUV lithographic photomask, is capable of storing, outputting, or storing and outputting a value for the charge on the lithographic photomask, and is capable of causing the charge injector to modify the charge on the EUV lithographic photomask a specified amount.

2. The assembly of claim 1, wherein the assembly comprises a plurality of charge injectors.

3. The assembly of claim 1 or claim 2, additionally comprising at least part of a carrier for an EUV lithographic photomask, wherein the housing is attached to the at least part of a carrier for an EUV lithographic photomask.

4. The assembly of any of the preceding claims wherein the control unit is additionally capable of determining the specified amount from a measurement of electrostatic charge on the EUV lithographic photomask and a selected value for electrostatic charge on the EUV lithographic photomask.

5. A system comprising:
a sensor, wherein the sensor is capable of measuring electrostatic charge on a lithographic photomask;
a charge injector, wherein the charge injector is capable of modifying the electrostatic charge on a lithographic photomask;
a housing wherein the sensor and the charge injector are in the housing;
a control unit wherein the control unit is capable of causing the sensor to measure the charge on a lithographic photomask, is capable of outputting, or storing and outputting a value for the charge on the lithographic photomask, and is capable of causing the charge injector to modify the charge on a lithographic photomask a specified amount; and
a computing system, wherein the computing system is capable of determining an amount for modifying the electrostatic charge on a lithographic photomask based on a selected value for electrostatic charge and an output value from the control unit, and wherein the computing system is communicatively coupled to the control unit.

6. The system of claim 5, wherein the computing system is additionally capable of creating a map of charge amount for the lithographic photomask surface where the map includes lithographic photomask surface locations and charge amounts.

7. The system of claim 5 or claim 6, wherein the system comprises a plurality of sensors in the housing.

8. The system of any of claims 5-7, wherein the lithographic photomask is an extreme ultraviolet lithographic photomask.

9. A method for modifying electrostatic charge on an extreme ultraviolet (EUV) lithographic photomask comprising:
measuring electrostatic charge on an EUV lithographic photomask;
calculating an amount that the measured electrostatic charge on the EUV lithographic photomask is to be changed based on a selected electrostatic charge amount and the measured electrostatic charge amount; and
modifying the amount of electrostatic charge on the EUV lithographic photomask based on the calculated amount.

10. The method of claim 9 also including measuring electrostatic charge on the EUV lithographic photomask a second time.

11. The method of claim 9 or claim 10 wherein modifying the amount of electrostatic charge on the EUV lithographic photomask includes decreasing the amount of electrostatic charge on the EUV lithographic photomask.

12. The method of any of claims 9-11 also including creating a map of electrostatic charge amount for the EUV lithographic photomask where the map includes EUV lithographic photomask surface locations and electrostatic charge amounts.

13. The method of any of claims 9-12, also including measuring electrostatic charge on the EUV lithographic photomask a second time and modifying the amount of electrostatic charge on the EUV lithographic photomask based on a calculated amount.

14. At least one machine-readable storage medium comprising non-transitory instructions, that when executed by a processor, cause a device to implement a method as claimed in any of claims 9-13.

15. An apparatus comprising a means to perform a method as claimed in any of claims 9-13.
